# EUROPEAN PATENT SPECIFICATION

(11) **EP 4 141 966 B1**
(45) Date of publication and mention of the grant of the patent: **18.02.2026**
(21) Application number: 21867893.6
(22) Date of filing: 30.10.2021
(51) Int. Cl.: H10F 10/166, H10F 77/20, H10F 77/30, H10F 71/00

(54) **SOLAR CELL**
SOLARZELLE
CELLULE SOLAIRE

(30) Priority: 04.07.2021 CN 202110754052; 04.07.2021 CN 202110754051
(43) Date of publication of application: 01.03.2023
(73) Proprietor: Beijing Zenithnano Technology Co., Ltd., Beijing 100094 (CN)
(72) Inventor: ZHANG, Yuchun, Beijing 100094 (CN); ZHONG, Shudong, Beijing 100094 (CN)
(74) Representative: Bayramoglu et al.
(86) International application number: PCT/CN2021/127785
(87) International publication number: WO 2023/279598

(56) References cited:
- CN-A- 106 340 570
- CN-A- 106 601 861
- CN-A- 108 987 488
- CN-A- 109 004 039
- CN-A- 110 649 129
- CN-A- 111 384 186
- CN-A- 111 446 028
- CN-A- 111 446 028
- CN-A- 111 710 759
- CN-A- 111 710 759
- CN-A- 113 488 548
- CN-A- 113 488 556
- CN-A- 113 488 556
- CN-U- 202 549 860
- CN-U- 212 848 452
- CN-U- 212 848 452
- JP-A- 2013 161 822
- US-A1- 2018 212 083
- ALAN E DELAHOY ET AL: "Transparent Conducting Oxides for Photovoltaics", HANDBOOK OF PHOTOVOLTAIC SCIENCE AND ENGINEERING, SECOND EDITION, 21 December 2010 (2010-12-21), Chichester, UK, pages 716 - 796, XP055113336, Retrieved from the Internet <URL:http://onlinelibrary.wiley.com/store/10.1002/9780470974704.ch17/asset/ch17.pdf?v=1&t=httq5av5&s=715bf24b1ef9939078e15755bc65ffe9a23689ca> [retrieved on 20140410], DOI: 10.1002/9780470974704.ch17
- LEONARD TUTSCH ET AL: "The sputter deposition of broadband transparent and highly conductive cerium and hydrogen co-doped indium oxide and its transfer to silicon heterojunction solar cells", PROGRESS IN PHOTOVOLTAICS: RESEARCH AND APPLICATIONS, JOHN WILEY & SONS, LTD, HOBOKEN, USA, vol. 29, no. 7, 5 February 2021 (2021-02-05), pages 835 - 845, XP071979562, ISSN: 1062-7995, DOI: 10.1002/PIP.3388
- KOBAYASHI EIJI ET AL: "Cerium oxide and hydrogen co-doped indium oxide films for high-efficiency silicon heterojunction solar cells", SOLAR ENERGY MATERIALS AND SOLAR CELLS, ELSEVIER SCIENCE PUBLISHERS, AMSTERDAM, NL, vol. 149, 22 January 2016 (2016-01-22), pages 75 - 80, XP029454584, ISSN: 0927-0248, DOI: 10.1016/J.SOLMAT.2016.01.005

## Description

### TECHNICAL FIELD

The present disclosure relates to the field of photovoltaics, and in particular to solar cells.

### BACKGROUND

Solar cells are designed to directly convert light energy into electricity. According to the photovoltaic effect, solar cells made of a single semiconductor material can only convert a part of the light energy in the solar radiation spectrum into electrical energy, which results in low energy conversion efficiency and low output voltage. Heterojunction solar cells are promising due to their bifacial power generation performance, but their photoelectric conversion efficiency still needs to be improved.

The utility model publication no. CN202549860U discloses a heterojunction solar cell. The cell comprises a substrate made of an N-type monocrystalline silicon material; an intrinsic layer, a P-type amorphous silicon thin film layer, a transparent conductive oxide thin film layer and a front side metal electrode are sequentially deposited at the side of the right side of the substrate; an intrinsic layer, an N-type amorphous silicon thin film, a transparent conductive oxide thin film layer and a reverse side metal electrode are sequentially deposited at the side of the reverse side of the substrate; and the intrinsic layers are intrinsic amorphous silicon thin film layers or intrinsic amorphous silicon oxygen thin film layer and have the thicknesses of 3 to 20 nm.

The patent document publication no. CN111710759A discloses a method for treating the surface of a silicon-based heterojunction solar cell transparent conductive oxide film. The method comprises the following steps: (1) depositing intrinsic amorphous silicon or amorphous silica films on the upper surface and the lower surface of a silicon wafer; (2) respectively depositing a P-type doped amorphous silicon film and an N-type doped amorphous silicon film on the upper surface and the lower surface of the silicon wafer obtained in the step (1), or depositing amorphous silica films on the upper surface and the lower surface of the silicon wafer; (3) depositing TCO films on the upper surface and the lower surface of the silicon wafer obtained in the step (2); (4) carrying out surface treatment on the TCO film by adopting plasma, wherein the surface treatment comprises roughening treatment and modification treatment.

The utility model publication no. CN212848452U discloses a heterojunction solar cell and a manufacturing method thereof. An amorphous layer is arranged on the side surface of a monocrystalline silicon substrate of the heterojunction solar cell, and the heterojunction solar cell is based on the specific structure of the heterojunction solar cell provided by the utility model. According to the single crystal silicon substrate, electric leakage caused by direct contact formed between the first transparent conductive film layer and the single crystal silicon substrate and between the second transparent conductive film layer and the single crystal silicon substrate can be avoided, the damage risk of the edge of the single crystal silicon substrate is reduced, and the passivation effect of the side face of the single crystal silicon substrate can be effectively improved due to the fact that the side face of the single crystal silicon substrate is covered by the intrinsic structure film.

The patent publication no. CN109004039A discloses a solar cell chip and a preparation method thereof. The solar cell chip comprises a substrate; at least one surface of the substrate is sequentially provided with an intrinsic passivation layer, a silicon doping layer, a transparent conductive layer and an electrode; an antireflection layer is arranged on one side of the transparent conductive layer away from the silicon doping layer; the electrode is arranged on the transparent conductive layer through the antireflection layer; the electrode includes a first gate line lamination and a second gate line lamination; the first gate line lamination is disposed on the transparent conductive layer, and the second gate line lamination is disposed on the first gate line lamination.

The patent publication no. CN111384186A discloses a reworking method of a heterojunction battery piece, which comprises the following steps of: (1) immersing a winding end of the heterojunction battery piece into corrosive liquid for corrosion, and arranging an auxiliary electrode grid line on the heterojunction battery piece; and (2) after the corrosion is finished, taking out the battery piece and carrying out post-treatment. According to the invention, the auxiliary electrode grid lines are arranged at the edge of the battery piece, so that by means of an isotropic reaction principle that high-concentration alkali is easy to corrode, the silicon thin film doped layer at the edge winding end of the battery piece is successfully removed, and electricity caused by short circuit at the edge of the battery piece is avoided.

The patent publication no. CN111446028A discloses a transparent conductive film and a touch screen. The transparent conductive film comprises a base material, at least two IM layers and a conductive layer which are successively arranged in a stack mode, wherein the two IM layers sequentially include an organic material layer and an inorganic material layer which are arranged on the base material; the conductive layer sequentially includes a metal doped layer and a transparent conductive material layer which are arranged on the IM layers; and the metal doped layer includes metal and nitride metal and/or metal and oxide metal.

The non-patent document "Transparent Conductive Oxides for Photovoltaics" (Alan E. Delahoy et al., Handbook of Photovoltaic Science and Engineering, Second Edition, 21 December 2010, p. 716-796) discloses solar cells that incorporate one or more Transparent Conductive Oxide (TCO) layers in their construction. This document reviews the materials used for transparent conducting oxides, the doping process, properties of TCOs used in photovoltaic (PV) applications, and deposition methods.

The patent document publication no. JP2013161822A discloses solar battery and method of manufacturing the same, and solar battery module. The features of the invention are that: an intrinsic semiconductor film layer and an amorphous semiconductor film layer of the first conductivity type or the second conductivity type on each of the first main surface and the second main surface of the crystalline semiconductor substrate of the first conductivity type or the second conductivity type; a transparent conductive film layer and a collector electrode are stacked in this order, and in at least one of the first main surface and the second main surface, the transparent conductive film layer partially applies stress in the surface direction of the transparent conductive film layer. A solar cell characterized by having a stress relaxation region to be relaxed in a part of the region directly below the collector electrode.

The patent document no. CN108987488A discloses a silicon heterojunction solar cell and preparation method thereof. The silicon heterojunction solar cell comprises an n-type crystalline silicon substrate; first lightly doped n-type hydrogenated amorphous silicon layer; heavily doped p-type hydrogenated amorphous silicon emitter layer; a first transparent conductive oxide layer; second lightly doped n-type hydrogenated amorphous silicon layer; heavily doped n-type hydrogenated amorphous silicon back field layer; a second transparent conductive oxide layer; and a plurality of metal gate line electrode layers. The silicon heterojunction solar cell uses lightly doped hydrogenated amorphous silicon instead of intrinsic amorphous silicon as the passivation layer, which can significantly improve the series resistance and improve the battery performance on the premise of ensuring good interface passivation.

The patent document no. CN106340570A discloses a film plating device for preparing TCO (Transparent Conductive Oxide) film and film plating method. The film plating device integrates an ion film plating source with a sputtering film plating source in the same vacuum equipment. Characteristics of ion film plating and sputtering film plating are combined effectively, TCO films of different optical and electrical properties are prepared continuously under the condition that the films are not exposed in the atmosphere according to different requirements for the TCO films of devices, a high deposition speed is obtained, and damage on a substrate and the device surface caused in the film deposition process is reduced. The device and method are especially suitable for preparing the TCO films continuously in the front and back sides of high-efficiency film silicon/crystalline silica heterojunction solar cells with low loss as well as preparing different TCO films continuously in different film solar cells; and the device and method are suitable for different TCO materials with different performances.

Non-patent documents Leonard Tutsch et al: "The sputter deposition of broadband transparent and highly conductive cerium and hydrogen co-doped indium oxide and its transfer to silicon heterojunction solar cells", PROGRESS IN PHOTOVOLTAICS: RESEARCH AND APPLICATIONS, vol. 29, no. 7, 5 February 2021, p. 835-845 and Kobayashi Eiji et al: "Cerium oxide and hydrogen co-doped indium oxide films for high-efficiency silicon heterojunction solar cells", SOLAR ENERGY MATERIALS AND SOLAR CELLS, vol. 149, 22 January 2016, p. 75-80 disclose cerium doped indium oxide layers for silicon heterojunction solar cells.

While the prior art documents mentioned above offer various solar cell structures and materials to achieve high efficiency, the issue of resistance persists. Therefore, the need for a heterojunction solar cell with reduced resistance and high efficiency remains.

### SUMMARY

In order to solve the above problem, the present disclosure provides a heterojunction solar cell. The heterojunction solar cell includes, as defined in claim 1: an N-type wafer, where an i-type amorphous silicon oxide layer, a p-type amorphous silicon layer and a first metal oxides-mixed conductive layer are sequentially arranged on a first surface of the N-type wafer; an i-type amorphous silicon oxide layer, an n-type amorphous silicon layer, and a second metal oxides-mixed conductive layer are sequentially arranged on a second surface of the N-type wafer; each of the first and second metal oxides-mixed conductive layers comprises In₂O₃ and an oxide of a subgroup metal; the oxide of the subgroup metal is CeO₂, such that the each of the first and second metal oxides-mixed conductive layers comprises In₂O₃ and CeO₂, wherein a mass ratio of In₂O₃ in the first and second metal oxides-mixed conductive layers is 97.5wt%, a mass ratio of CeO₂ in the first and second metal oxides-mixed conductive layers is 2.5wt%, and a final thickness of the first and second metal oxides-mixed conductive layers is 80 nm.

Preferably, the first surface defines a front side.

Preferably, the second surface defines a back side.

Compared with the prior art, the present disclosure has the following beneficial effects. (1) The present disclosure provides a metal oxides-mixed conductive layer in the solar cell, which significantly improves the mobility of carriers, reduces transmittance and resistance, and effectively improves photoelectric conversion efficiency. (2) The present disclosure provides a composite conductive layer in the solar cell, which improves the transmittance of the heterojunction solar cell and further reduces the resistance, thereby improving the efficiency of the heterojunction solar cell.

### BRIEF DESCRIPTION OF THE DRAWINGS

The drawings described here are provided for further understanding of the present disclosure, and constitute a part of the present disclosure. The exemplary embodiments of the present disclosure and illustrations thereof are intended to explain the present disclosure, but do not constitute inappropriate limitations to the present disclosure. Drawings:
FIG. 1 is a structural diagram of an exemplary heterojunction solar cell (not constituting a part of the present invention);
FIG. 2 is a structural diagram of another exemplary heterojunction solar cell;
FIG. 3 is a structural diagram of a heterojunction solar cell according to a first embodiment of the present disclosure (not constituting a part of the present invention);
FIG. 4 is a structural diagram of a heterojunction solar cell according to a second embodiment of the present disclosure (not constituting a part of the present invention);

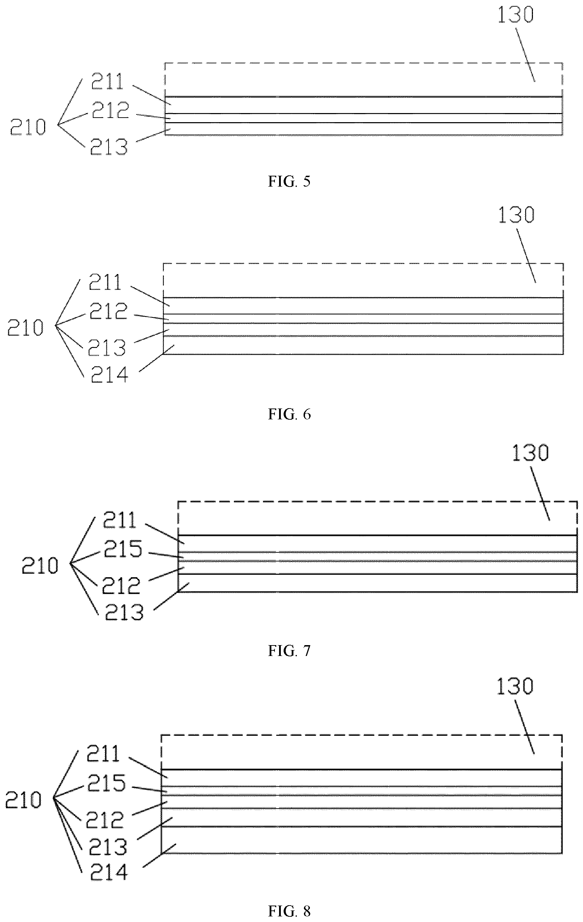

FIG. 5 shows a first structure of a composite conductive layer (not constituting a part of the present invention);
FIG. 6 shows a second structure of the composite conductive layer (not constituting a part of the present invention);
FIG. 7 shows a third structure of the composite conductive layer (not constituting a part of the present invention); and
FIG. 8 shows a fourth structure of the composite conductive layer (not constituting a part of the present invention).

### DETAILED DESCRIPTION OF THE EMBODIMENTS

To make the objective, technical solutions, and advantages of the present disclosure clearer, the technical solutions in the present disclosure are clearly and completely described below with reference to specific embodiments and corresponding drawings of the present disclosure.

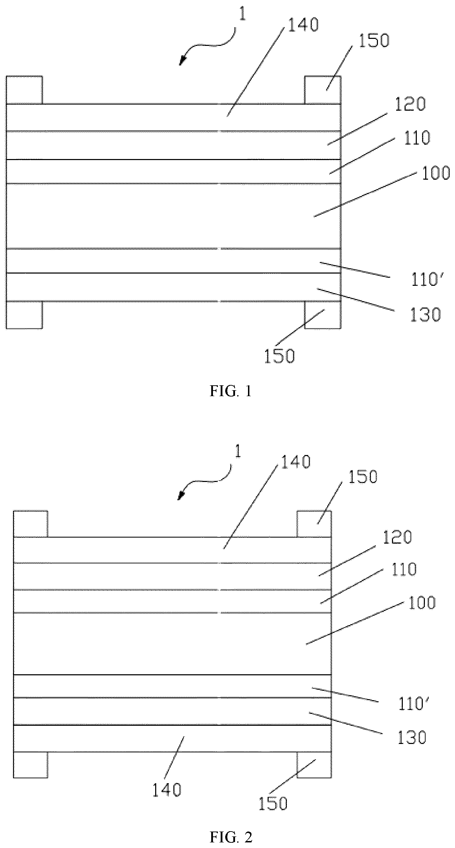

FIG. 1 is a structural diagram of an exemplary heterojunction solar cell 1. As shown in FIG. 1, the heterojunction solar cell 1 includes: an N-type wafer 100, where an i-type amorphous silicon oxide layer 110, a p-type amorphous silicon layer 120 and a metal oxides-mixed conductive layer 140 are sequentially arranged on a first surface of the N-type wafer; an i-type amorphous silicon oxide layer 110' and an n-type amorphous silicon layer 130 are sequentially arranged on a second surface of the N-type wafer; and the metal oxides-mixed conductive layer 140 includes In₂O₃ and an oxide of at least one subgroup metal.

In the present disclosure, the heterojunction solar cell 1 uses a metal oxides-mixed conductive layer 140 including In₂O₃ and a subgroup metal oxide. In the prior art, ITO is often used as the conductive layer, and the mobility of carriers of the traditional ITO conductive layer is only 30-40 cm²/(V*s). In comparison, the metal oxides-mixed conductive layer 140 of the present disclosure (equivalent to replacing at least part of Sn in ITO with a subgroup element) can significantly improve the mobility of carriers and effectively improve the photoelectric conversion efficiency.

It should be understood that, in order to facilitate connection with external circuits, a silver gate line 150 is further formed on the mixed oxide conductive layer 140. A similar silver gate line 150 is further formed on the n-type amorphous silicon layer 130. It should also be understood that, in the example shown in FIG. 1, the first surface defines a front side, that is, a side facing the sun, and the second surface defines a back side, that is, a side facing away from the sun.

In another example, as shown in FIG. 2, the metal oxides-mixed conductive layer 140 is provided on the n-type amorphous silicon layer 130 (i.e. on the side defined by the second surface). This helps to improve the photoelectric conversion efficiency of the heterojunction solar cell 1.

Heterojunction solar cells with the above-mentioned metal oxides-mixed conductive layer were fabricated experimentally, and their related properties were tested.

Example 1 (not constituting a part of the present invention): In and W oxides-mixed conductive layers are provided on both the p-type amorphous silicon layer 120 and the n-type amorphous silicon layer 130.

Under the atmosphere of Ar and oxygen, an oxide target of In and W is bombarded, and the In and W oxides-mixed conductive layers are deposited. By controlling the amount of oxygen introduced and the deposition process, the mass ratio of WO₂ in the metal oxides-mixed conductive layers is controlled to be 1-10wt%, and the final film thickness is controlled to be 50-150 nm. The parameters of the heterojunction solar cell with the metal oxides-mixed conductive layer of this example are shown in Table 1.

Example 2: In and Ce oxides-mixed conductive layers are provided on both the p-type amorphous silicon layer 120 and the n-type amorphous silicon layer 130.

Under the atmosphere of Ar and oxygen, an oxide target of In and Ce is bombarded, and In and Ce oxides-mixed conductive layers are deposited. By controlling the amount of oxygen introduced and the deposition process, the mass ratio of CeO₂ in the metal oxides-mixed conductive layers is controlled to be 1-5wt%, and the final film thickness is controlled to be 50-150 nm. The parameters of the heterojunction solar cell with the metal oxides-mixed conductive layer of this example are shown in Table 1.

Example 3 (not constituting a part of the present invention): An In and Ti oxides-mixed conductive layer is provided on the p-type amorphous silicon layer 120 alone.

Under the atmosphere of Ar and oxygen, an oxide target of In and Ti is bombarded, and the In and Ti oxides-mixed conductive layer is deposited. By controlling the amount of oxygen introduced and the deposition process, the mass ratio of TiO₂ in the metal oxides-mixed conductive layer is controlled to be 0.1-1wt%, and the final film thickness is controlled to be 50-150 nm. The parameters of the heterojunction solar cell with the metal oxides-mixed conductive layer of this example are shown in Table 1.

Example 4 (not constituting a part of the present invention): An In and Zn oxides-mixed conductive layer is provided on the n-type amorphous silicon layer 130 alone.

Under the atmosphere of Ar and oxygen, an oxide target of In and Zn is bombarded, and the In and Zn oxides-mixed conductive layer is deposited. By controlling the amount of oxygen introduced and the deposition process, the mass ratio of ZnO₂ in the metal oxides-mixed conductive layer is controlled to be 1-5wt%, and the final film thickness is controlled to be 50-150 nm. The parameters of the heterojunction solar cell with the metal oxides-mixed conductive layer of this example are shown in Table 1.

Example 5 (not constituting a part of the present invention): In and Mo oxides-mixed conductive layers are provided on both the p-type amorphous silicon layer 120 and the n-type amorphous silicon layer 130.

Under the atmosphere of Ar and oxygen, an oxide target of In and Mo is bombarded, and the In and Mo oxides-mixed conductive layers are deposited. By controlling the amount of oxygen introduced and the deposition process, the mass ratio of Mo₂O₃ in the metal oxides-mixed conductive layers is controlled to be 1-10wt%, and the final film thickness is controlled to be 50-150 nm. The parameters of the heterojunction solar cell with the metal oxides-mixed conductive layer of this example are shown in Table 1.

Example 6 (not constituting a part of the present invention): An In and Zr oxides-mixed conductive layer is provided on the p-type amorphous silicon layer 120 alone.

Under the atmosphere of Ar and oxygen, an oxide target of In and Zr is bombarded, and the In and Zr oxides-mixed conductive layer is deposited. By controlling the amount of oxygen introduced and the deposition process, the mass ratio of ZrO₂ in the metal oxides-mixed conductive layer is controlled to be 1-10wt%, and the final film thickness is controlled to be 50-150 nm. The parameters of the heterojunction solar cell with the metal oxides-mixed conductive layer of this example are shown in Table 1.

Example 7 (not constituting a part of the present invention): In, W and Sn oxides-mixed conductive layers are provided on both the p-type amorphous silicon layer 120 and the n-type amorphous silicon layer 130.

Under the atmosphere of Ar and oxygen, an oxide target of In, W and Sn is bombarded, and the In, W and Sn oxides-mixed conductive layers are deposited. By controlling the amount of oxygen introduced and the deposition process, the mass ratios of WO₂ and SnO₂ in the metal oxides-mixed conductive layers are controlled to be 1-10wt% and 1-10wt% respectively, and the final film thickness is controlled to be 50-150 nm. The parameters of the heterojunction solar cell with the metal oxides-mixed conductive layer of this example are shown in Table 1.

### Comparative Example 1: ITO conductive layer

ITO conductive layers commonly used in solar cells on the market are selected, and their related properties are shown in Table 1.

**Table 1 (Examples 1, 3-7 do not constitute a part of the present invention)**

| | Material | | Mass ratio | Thickness nm | Transmittance % (300-1,100 nm) | Resistance ohm | Mobility cm²/(V*s) | Photoelectri c conversion efficiency |
|---|---|---|---|---|---|---|---|---|
| Example 1 | IWO | In₂O₃:WO₂ | 98:2 | 80 | 84 | 65 | 80~90 | 24.5% |
| Example 2 | ICO | In₂O₃:CeO₂ | 97.5:2. 5 | 80 | 83 | 70 | 140~150 | 25.3% |
| Example 3 | ITiO | In₂O₃:TiO₂ | 99.7:0. 3 | 80 | 84 | 75 | 50~60 | 24.3% |
| Example 4 | IZO | In₂O₃:ZnO₂ | 98:2 | 80 | 85 | 72 | 40~50 | 24.1% |
| Example 5 | IMO | In₂O₃:Mo₂O₃ | 99:1 | 80 | 83 | 67 | 60~70 | 24.4 |
| Example 6 | IZrO | In₂O₃:ZrO2 | 98:2 | 80 | 84 | 71 | 50~60 | 24.3% |
| Example 7 | IWSO | In₂O₃:SnO2:WO₂ | 98:1:1 | 80 | 86 | 61 | 100~110 | 24.8% |
| Comparative Example 1 | ITO | In₂O₃:SnO₂ | 97:3 | 80 | 82 | 60 | 30~40 | 23.5% |

It can be seen from Table 1 that the photoelectric conversion efficiency of the heterojunction solar cell is improved by replacing the ITO in the prior art with the metal oxides-mixed conductive layer 140 of the present disclosure.

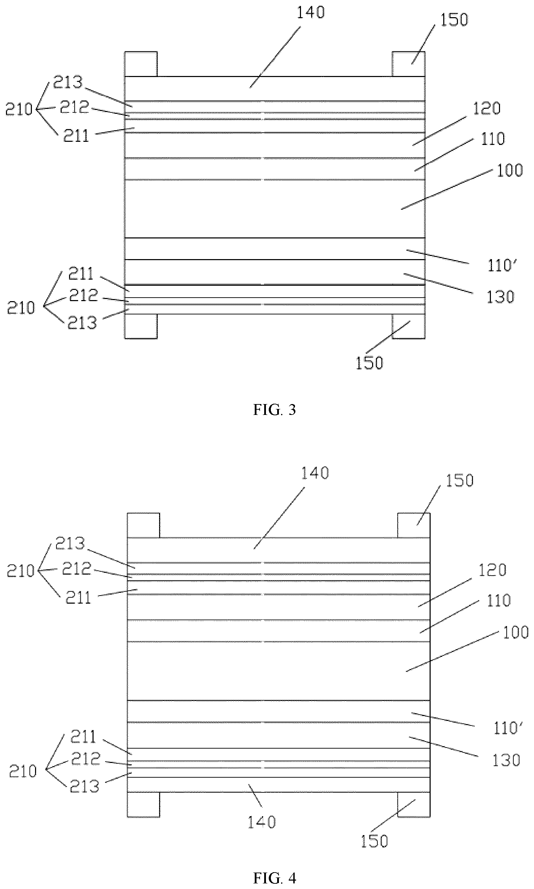

As shown in FIG. 3, a composite conductive layer 210 is provided on each (or on either) of the n-type amorphous silicon layer 130 and the p-type amorphous silicon layer 120. The composite conductive layer 210 includes an anti-reflection layer 211, a mixture coating 212 and a transparent conductive layer 213. The anti-reflection layer 211 is in electrical contact with the p-type amorphous silicon layer 120 or the n-type amorphous silicon layer 130. The mixture coating 212 is made of a metal mixed with a metal oxide, a metal mixed with a metal nitride, or a metal mixed with a metal oxide and a metal nitride. The anti-reflection layer 211 is in electrical contact with the n-type amorphous silicon layer 130, and a silver gate line 216 is further formed on the transparent conductive layer 213 to connect an external circuit.

The composite conductive layer 210 is formed on the n-type amorphous silicon layer 130 and/or the p-type amorphous silicon layer 120. This increases the transmittance of the heterojunction solar cell 1 and further reduces the resistance thereof, thereby increasing the efficiency of the heterojunction solar cell 1.

As shown in FIG. 4, the metal oxides-mixed conductive layer 140 as described above is further formed on the composite conductive layer 210. That is, the transparent conductive layer 213 is in contact with the metal oxides-mixed conductive layer 140. A silver gate line 216 is formed on the metal oxides-mixed conductive layer 140. With this structure, the heterojunction solar cell 1 has high transmittance and low resistance, thereby achieving high photoelectric conversion efficiency.

In an embodiment, the anti-reflection layer 211 is made of one from the group consisting of Nb₂O₅, Ta₂O₅, TiO₂, SiN, ZnO and TiN, and has a thickness of 25-45 nm. The anti-reflection layer 211 is used to improve the sunlight injection efficiency of the back side of the heterojunction solar cell 1, thereby improving the efficiency of the heterojunction solar cell 1.

In an embodiment, the transparent conductive layer 213 is made of a metal oxide, and has a thickness of 35-60 nm. The metal oxide is one or more from the group consisting of In₂O₃, SnO₂, ZnO, ITO, IZO, AZO, ITiO, ITiZO and FTO. In an embodiment, the ITO is doped with 0-50wt% of SnO₂; the IZO is doped with 0-50wt% of ZnO; the AZO is doped with 0-50wt% of Al₂O₃; the ITiO is doped with 0-10wt% of TiO₂; the ITiZO is doped with 0-10wt% of TiO₂ and 0-40wt% of ZnO; and the FTO is doped with 0-10wt% of F.

In an embodiment, a mixture coating 212 with a thickness of less than 10 nm is added on the basis of the transparent conductive layer 213 to further reduce the resistance of the composite conductive layer 210. The mixture coating 212 is fabricated by a physical vapor deposition (PVD) process. A small amount of oxygen and/or nitrogen is introduced into a reaction chamber. By controlling the amount of the gas introduced, the metal sputtered by a metal target is not completely reacted, and the mixture coating 212 can be formed as required.

The mixture coating 212 and the transparent conductive layer 213 are provided on the anti-reflection layer 211. This lowers the resistance and further improves the solar injection efficiency of the back side of the heterojunction solar cell 1, thereby further improving the efficiency of the heterojunction solar cell 1.

In an embodiment, a conductive weather-resistant layer 214 is further provided between the mixture coating 212 and the transparent conductive layer 213. The weather-resistant layer 214 has a thickness of 2-200 nm, and is made of one from the group consisting of TiN, ZnO, TiO₂, SnO₂, SiO₂, Si₃N₄, AZO, IZO and YZO. The weather-resistant layer 214 can prevent the mixture coating 212 from being eroded by water vapor, oxygen, etc. in the environment, ensure the performance stability of the composite conductive layer 210, and prolong the service life.

Heterojunction solar cells with a composite conductive layer 210 on the back side were also fabricated, and the composition of the composite conductive layer is shown in Table 2. In Embodiments 1 to 4, the composite conductive layer is located on the back side of the heterojunction solar cell. In Embodiments 5 and 6, the composite conductive layer is located on the front side of the heterojunction solar cell. In Embodiment 7, the composite conductive layer is located on both sides of the heterojunction solar cell. In the Comparative Embodiment, ITO is used. The performance test results of Embodiments 1 to 7 and Comparative Embodiment 8 are shown in Table 3.

**Table 2 (not constituting a part of the present invention)**

| | Anti-reflection layer | Mixture coating | Weather-resistant layer | Transparent conductive layer |
|---|---|---|---|---|
| Embodiment 1 | Nb₂O₅-40nm | Ag+AgO-8nm | ZnO-5nm | ITO-42nm |
| Embodiment 2 | TiO₂-45nm | AgZn+AZnO-10mn | ZnO-3nm | ITiO-50nm |
| Embodiment 3 | SIN-38nm | AlTi+AlTiO-6nm | SnO₂-5nm | IZO-38mn |
| Embodiment 4 | Ta₂O₅-42nm | Cu+CuN-8nm | - | AZO-55nm |
| Embodiment 5 | Nb₂O₅-40nm | AgMg-AgMgO-12nm | SnO₂-7nm | FTO-46nm |
| Embodiment 6 | ZnO-32nm | Ag+AgO-10nm | NiO₂-5nm | ZnO-58nm |
| Embodiment 7 | TiN-28mn | AgTi+AgTiO-15nm | Ta₂O₅-7nm | AZO-41nm |

**Table 3 (not constituting a part of the present invention)**

| | Transmittance % (300-1,100 nm) | Resistance ohm | Mobility (cm²/(vs)) | Efficiency (%) |
|---|---|---|---|---|
| Embodiment 1 | 86.7 | 15 | 50~60 | 24.2 |
| Embodiment 2 | 87.7 | 10 | 50~60 | 24.8 |
| Embodiment 3 | 84 | 20 | 50~60 | 24.2 |
| Embodiment 4 | 84.5 | 17 | 50~60 | 24.1 |
| Embodiment 5 | 87.1 | 7.8 | 50~60 | 24.6 |
| Embodiment 6 | 86.5 | 14.5 | 50~60 | 24.3 |
| Embodiment 7 | 86.4 | 6.5 | 50~60 | 24.1 |
| Comparative Embodiment 8 | 82 | 60 | 30~40 | 23.5 |

It can be seen from Table 3 that the use of the composite conductive layer of the present disclosure in the heterojunction solar cell reduces the resistance, improves the transmittance and mobility, and thus improves the photoelectric conversion efficiency of the heterojunction solar cell.

## Claims

1. A heterojunction solar cell, comprising:
an N-type wafer (100), wherein
an i-type amorphous silicon oxide layer (110), a p-type amorphous silicon layer (120), and a first metal oxides-mixed conductive layer (140) are sequentially arranged on a first surface of the N-type wafer (100);
an i-type amorphous silicon oxide layer (110'), an n-type amorphous silicon layer (130), and a second metal oxides-mixed conductive layer (140) are sequentially arranged on a second surface of the N-type wafer (100);
each of the first and second metal oxides-mixed conductive layers (140) comprises In₂O₃ and an oxide of a subgroup metal; and
the oxide of the subgroup metal is CeO₂, such that the each of the first and second metal oxides-mixed conductive layers (140) comprises In₂O₃ and CeO₂, and wherein a mass ratio of In₂O₃ in the first and second metal oxides-mixed conductive layers (140) is 97.5wt%, a mass ratio of CeO₂ in the first and second metal oxides-mixed conductive layers (140) is 2.5wt%, and a final thickness of the first and second metal oxides-mixed conductive layers (140) is 80 nm.

2. The heterojunction solar cell according to claim 1, wherein the first surface defines a front side.

3. The heterojunction solar cell according to claim 1, wherein the second surface defines a back side.

## Patentansprüche

1. Eine Heteroübergangs-Solarzelle, umfassen:
eine N-Typ-Wafer (100), wobei
eine i-Typ amorphe Siliciumoxid-Schicht (110), eine p-Typ amorphe Silicium-Schicht (120) und eine erste Metalloxide-gemischte leitfähige Schicht (140) sequenziell auf einer ersten Oberfläche des N-Typ-Wafers (100) angeordnet sind;
eine i-Typ amorphe Siliciumoxid-Schicht (110'), eine n-Typ amorphe Silicium-Schicht (130) und eine zweite Metalloxide-gemischte leitfähige Schicht (140) sequenziell auf einer zweiten Oberfläche des N-Typ-Wafers (100) angeordnet sind;
jede der ersten und zweiten Metalloxide-gemischten leitfähigen Schichten (140) In₂O₃ und ein Oxid eines Untergruppenelements umfasst; und
das Oxid des Untergruppenelements CeO₂ ist, sodass jede der ersten und zweiten Metalloxide-gemischten leitfähigen Schichten (140) In₂O₃ und CeO₂ umfasst, und wobei ein Massenverhältnis von In₂O₃ in den ersten und zweiten Metalloxide-gemischten leitfähigen Schichten (140) 97.5 Gew.-% ist, ein Massenverhältnis von CeO₂ in den ersten und zweiten Metalloxide-gemischten leitfähigen Schichten (140) 2.5 Gew.-% ist, und eine endgültige Dicke der ersten und zweiten Metalloxide-gemischten leitfähigen Schichten (140) 80 nm ist.

2. Heteroübergangs-Solarzelle nach Anspruch 1, wobei die erste Oberfläche eine Vorderseite definiert.

3. Heteroübergangs-Solarzelle nach Anspruch 1, wobei die zweite Oberfläche eine Rückseite definiert.

## Revendications

1. Cellule solaire à hétérojonction, comprenant :
une tranche de type N (100), dans laquelle
une couche d'oxyde de silicium amorphe de type i (110), une couche de silicium amorphe de type p (120) et une première couche conductrice mixte d'oxydes métalliques (140) sont disposées de manière séquentielle sur une première surface de la tranche de type N (100) ;
une couche d'oxyde de silicium amorphe de type i (110'), une couche de silicium amorphe de type n (130) et une deuxième couche conductrice mixte d'oxydes métalliques (140) sont disposées de manière séquentielle sur une deuxième surface de la tranche de type N (100) ;
chacune des première et deuxième couches conductrices mixtes d'oxydes métalliques (140) comprend du In₂O₃ et un oxyde d'un métal de sous-groupe ; et
l'oxyde du métal de sous-groupe est du CeO₂, de telle sorte que chacune des première et deuxième couches conductrices mixtes d'oxydes métalliques (140) comprend du In₂O₃ et du CeO₂, et dans laquelle un rapport massique du In₂O₃ dans les premières et deuxièmes couches conductrices mixtes d'oxydes métalliques (140) est de 97,5 % en poids, un rapport massique du CeO₂ dans les premières et deuxièmes couches conductrices mixtes d'oxydes métalliques (140) est de 2,5 % en poids, et une épaisseur finale des premières et deuxièmes couches conductrices mixtes d'oxydes métalliques (140) est de 80 nm.

2. Cellule solaire à hétérojonction selon la revendication 1, dans laquelle la première surface définit un côté avant.

3. Cellule solaire à hétérojonction selon la revendication 1, dans laquelle la deuxième surface définit un côté arrière.
